# EUROPÄISCHE PATENTSCHRIFT

(11) **EP 0 464 372 B1**
(45) Veröffentlichungstag und Bekanntmachung des Hinweises auf die Patenterteilung: **23.04.1997**
(21) Anmeldenummer: 91108781.5
(22) Anmeldetag: 29.05.1991
(51) Int. Cl.: H01L 31/18, H01L 21/318, H01L 21/316, H01L 21/311

(54) **Verfahren zur Herstellung und Passivierung von Halbleiterbauelementen**
Method of producing and passivating of semiconductor devices
Procédé pour fabriquer et passiver des dispositifs semi-conducteurs

(30) Priorität: 02.06.1990 DE 4017870
(43) Veröffentlichungstag der Anmeldung: 08.01.1992
(73) Patentinhaber: Alcatel SEL Aktiengesellschaft, D-70435 Stuttgart (DE); ALCATEL N.V., NL-1077 XX Amsterdam (NL)
(72) Erfinder: Bouayad-Amine, Jamal, W-7140 Ludwigsburg (DE); Kuebart, Wolfgang, W-7000 Stuttgart 1 (DE); Scherb, Joachim, W-7300 Esslingen-Zell (DE)
(74) Vertreter: Pechhold, Eberhard, Dipl.-Phys.

(56) Entgegenhaltungen:
- EP-A- 0 128 724
- GALLIUM ARSENIDE AND RELATED COMPOUNDS 1988 PROCEEDINGS OF THE 15TH INTERNATIONAL SYMPOSIUM ON GALLIUM ARSENIDE AND RELATED COMPOUNDS, 11. September 1988, Atlanta, Georgia, US, Seiten 405-408; M.I. BOWSER et al.: 'The effect of PECVD Si3N4 deposition and plasma pretreatments on the surface electronic properties of n-GaAs and SI-GaAs'
- LE VIDE, LES COUCHES MINCES, Bd. 45, Nr. 251, März 1990, Paris, FR, en 80-81; J.L. PEYRE et al.: 'Passivation des photodiodes à avalanche InP/InGaAs à structure planaire par dépôt de nitrure de silicium PECVD'
- LE VIDE, LES COUCHES MINCES, Bd. 43, Nr. 241, März 1988, Paris, FR, Seiten 229-230; N.L. NGUYEN et al.: 'Passivation de transistors à jonction sur GaInAs par dépôt de nitrure de silicium en PECVD'
- JOURNAL OF THE ELECTROCHEMICAL SOCIETY, Bd. 134, Nr. 3, März 1987, Manchester, New Hampshire, US, Seiten 665-668; T.J. FAITH et al.: 'Comparative investigation of CF4-Plasma, Ar-Plasma, and Dilute-HF-Dip Cleaning Methods for (Al-Si)/n+Si Contacts'

## Beschreibung

Die Erfindung betrifft ein Verfahren zur Herstellung und Passivierung von Bauelement-Bereichen auf einem III-V-Verbindungshalbleiter-Substrat.

Es ist seit geraumer Zeit bekannt, daß bei III-V-Verbindungshalbleitern eine sich während des Herstellungsprozesses auf der Halbleiteroberfläche bildende Eigenoxidschicht dafür verantwortlich ist, daß die elektrischen Eigenschaften von aus solchen Halbleitern hergestellten Bauelementen nicht so gut sind, wie sie aufgrund theoretischer überlegungen sein müßten und wie dies angestrebt wird.

Beispielsweise ist, wie dies einem Aufsatz von M. Taillepied und S. Goussier in "Appl. Phys. Lett" 48(15), 1986, Seiten 978 bis 980 zu entnehmen ist, der Drain-Strom von aus III-V-Verbindungshalbleitermaterial hergestellten Feldeffekttransistoren nicht stabil. Auch wird bei aus solchem Halbleitermaterial hergestellten Photodioden ein zu hoher Dunkelstrom gemessen, der bei optoelektronischen Anwendungen eine unerwünschte Rauschquelle darstellt. Die Verminderung dieses Dunkelstromes ist Gegenstand der veröffentlichten Europäischen Patentanmeldung 128 724.

Von verschiedenen Autoren wurden Verfahren angegeben, bei denen die unerwünschte Wirkung der Eigenoxidschicht bei der Herstellung von III-V-Verbindungshalbleiterbauelementen unterdrückt wird. Meist geschieht dies dadurch, daß die Ausbildung der Eigenoxidschicht verhindert oder zumindest verringert wird oder daß die entstandene Eigenoxidschicht vor Aufbringen einer Isolier- oder Passivierungsschicht gezielt entfernt wird.

In einem Aufsatz von P. Boher et al, der auf der Konferenz INFOS 1987 in Leuven, 13. bis 15.04.1987 vorgetragen und anschließend auch als Druckschrift veröffentlicht wurde und der der Erfindung am nächsten kommt, ist das Entfernen der Eigenoxidschicht durch Einwirkung eines Wasserstoff-Plasmas beschrieben. Trotz sofort anschließender Beschichtung der Substratoberfläche mit Siliciummitrid Si₃N₄ läßt sich jedoch eine Neubildung einer dünneren Eigenoxidschicht vor der Si₃N₄ Beschichtung nicht verhindern.

Das zuletzt erwähnte Verfahren führt zwar, wie zu erwarten, zur Verbesserung der elektrischen Werte der so hergestellten Halbleiterbauelemente. Diese erscheint jedoch noch nicht ausreichend.

Es ist Aufgabe der Erfindung, ein Verfahren der eingangs genannten Art anzugeben, nach dem die zur Herstellung der Halbleiterbauelemente benötigten Diffusionsmaskier- und Passivierschichten ohne eine die elektrischen Eigenschaften der Bauelemente verschlechternde Beeinträchtigung der Halbleiteroberfläche aufgebracht werden können.

Diese Aufgabe wird durch das Verfahren gemäß Anspruch 1 gelöst.

Die Vorbehandlung der Halbleiteroberfläche mittels einer Halogen-Kohlenstoff-Verbindung unter Plasmaeinwirkung bewirkt eine erhebliche Verringerung der Sperrströme an den erzeugten p-n-übergängen. So weisen mit entsprechend der Erfindung vorbehandelten Oberflächen erzeugte pin-Dioden sehr niedrige Dunkelströme auf. Bei Avalanche-Photodioden (APD's) zu beobachtende, auf Oberflächendegradation zurückzuführende Randdurchbrüche treten nicht mehr auf.

Diese Vorteile sind jedoch, im Gegensatz zum Stand der Technik, nicht auf ein Entfernen der Eigenoxidschicht zurückzuführen - diese bleibt im wesentlichen erhalten-, sondern gehen auf die Entstehung einer dünnen Schicht (möglicherweise einer Polymerschicht) zurück, welche den Halbleiter und seine Eigenoxidschicht während des nachfolgenden Schichtenauftrages vor direkter Einwirkung des Plasmas schützt.

Eine Ausgestaltung des Verfahrens nach der Erfindung ist im Patentanspruch 2 wiedergegeben und sieht die Verwendung von CF₄ als Halogen-Kohlenstoff-Verbindung vor. Diese Verbindung hat gute Resultate ergeben und außerdem den Vorteil, dasselbe Halogen zu enthalten wie viele zur Oberflächenvorbereitung benutzte, flußsäurehaltige Ätzmittel.

Weitere Ausgestaltungen der Erfindung betreffen die Plasmaerzeugung - vorzugsweise wird ein gewöhnlicher Parallelplattenreaktor verwendet - (Patentanspruch 3) und zur Anwendung des Verfahrens nach der Erfindung besonders geeignete Halbleiter-Isolierschicht-Kombinationen (Anspruch 4).

Anhand von 4 Figuren soll nun das Verfahren nach der Erfindung ausführlich beschrieben werden.

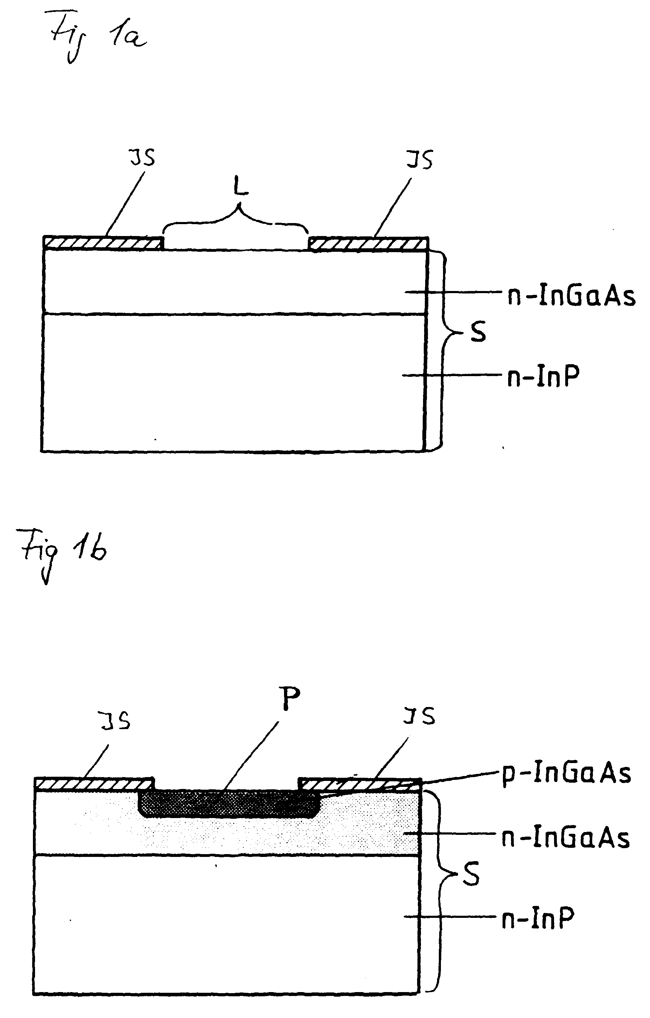

Fig. 1 zeigt eine bekannte planare InGaAs/InP-pin-Photodiode in verschiedenen Phasen ihrer Entstehung.

In Fig. 1a ist ein zweischichtiges Substrat S aus n-dotiertem Indiumphosphid InP und auf diesem aufgebrachten, ebenfalls n-dotiertem Indium-Galliumarsenid (InGaAs) dargestellt. Da in dieses Subtrat S zur Bildung eines p-leitenden Bereichs z.B. Zn oder Cd eindiffundiert werden soll, ist es zur Abgrenzung dieses Bereichs mit einer Isolierschicht IS aus SiOₓ, SiN_{y} oder SiOₓN_{y} überzogen, die photolithographisch mit einer Öffnung L vorgegebener Form und Fläche versehen wurde. Die Isolierschicht stellt damit eine Diffusionsmaske dar.

Fig. 1b zeigt das Substrat S mit dem durch Diffusion erzeugten, p-dotierten Bereich P und dem an dessen Grenze zum n-dotierten Substrat befindlichen, elektrisch wirksamen p-n-Übergang.

Fig. 1c, schließlich, zeigt die fertiggestellte pin-Photodiode mit aufgebrachten metallischen Kontakten K, einer Antireflexionsschicht A auf einer Lichteintrittsfläche und mit einer Passivierungschicht PS, die nach Entfernen der Diffusionsmaske den n-dotierten und den p-dotierten Bereich auf der Oberseite des Substrats bedeckt.

Das in Fig. 1a bis 1c in unterschiedlichen Aufbaustadien wiedergegebene Bauelement kann auf verschiedene Arten hergestellt werden. Der Aufbau der einzelnen Halbleiter- und Isolatorschichten kann z.B. durch Sputtern oder durch Abscheiden eines chemischen Reaktionsproduktes aus der Dampfphase (Chemical Vapor-Deposition CVD) erfolgen. Das zuletzt genannte Verfahren ist, je nachdem, ob zur Anregung der chemischen Reaktion Wärme, ein Plasma oder kurzwelliges Licht verwendet werden, als thermisches CVD, plasmaunterstütztes CVD (auch PECVD) oder Photo-CVD bekanntgeworden.

Das in Fig. 1a bis 1c dargestellte, auf herkömmliche Art und Weise hergestellte Bauelement weist unzureichende elektrische Eigenschaften, insbesondere einen zu hohen Sperrstrom (Dunkelstrom) auf. Durch verschiedene Untersuchungen, auf die hier nicht näher eingegangen werden soll, wurden als Ursache für diese Unzulänglichkeit Schädigungen der Halbleiteroberfläche im Bereich des p-n-Übergangs (Bereich B in Fig. 1c) festgestellt, die offenbar auf die Einwirkung einer auf der Halbleiteroberfläche vorhandenen Eigenoxidschicht bei der Aufbringung von Diffusionsmaskier- oder Passivierschichten zurückzuführen sind.

Das Verfahren nach der Erfindung, ein plasmaunterstütztes CVD-Verfahren, unterscheidet sich von herkömmlichen derartigen Verfahren dadurch, daß vor Aufbringung einer der Diffusionsmaskierung dienenden Isolierschicht oder einer Passivierungsschicht eine Vorbehandlung der zu beschichtenden Oberfläche in einem Halogen-Kohlenstoff-Plasma erfolgt. Hierzu wird die zu beschichtende Substratoberfläche nach Reinigung mit gepufferter Flußsäure in einen handelsüblichen PECVD-Parallelplattenreaktor eingebracht und auf eine Temperatur von etwa 200°C erwärmt. Über Ein- und Auslaßstutzen wird im Reaktor anschließend eine CF₄-Atmosphäre mit einem Druck von 0,8 mbar hergestellt und durch Anlegen einer HF-Spannung an die Elektrodenplatten des Reaktors ein Plasma erzeugt.

Nach einer Einwirkzeit des CF₄-Plasmas auf die Halbleiteroberfläche von z.B. 1 Minute wird das CF₄ durch andere, zum Aufbau der Isolier- oder Passivierschicht benötigte Reaktionsgase (z.B. SiH₄, N₂O, N₂) ersetzt und das Substrat für ca. 6 bis 7 Minuten beschichtet. Die entstehende Schicht kann dabei je nach Zusammensetzung der Reaktionsgase aus SiO₂, Si₃N₄ oder SiOₓN_{y} bestehen.

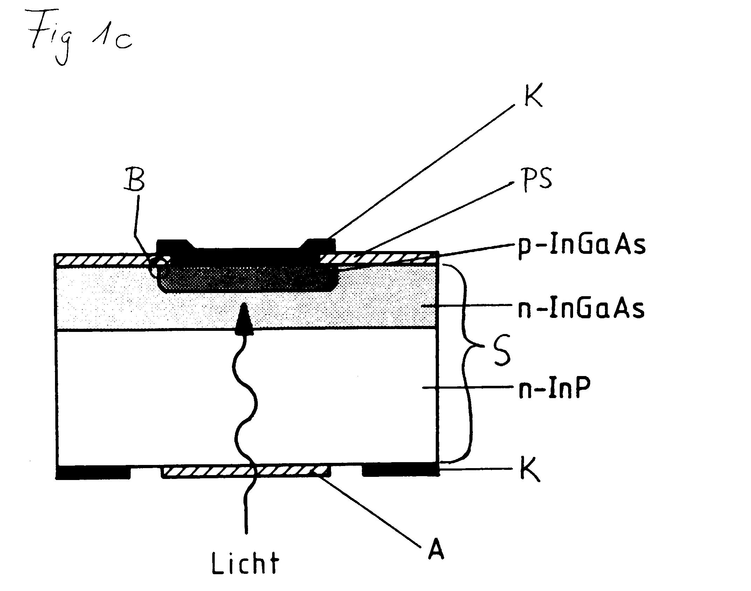

Die elektrischen Werte einer nach diesem Verfahren hergestellten Photodiode zeigen sich gegenüber denen der nach bekannten Verfahren hergestellten derartigen Bauelemente außerordentlich verbessert. In Fig. 2 sind z.B. Dunkelstromkennlinien je einer auf InGaAs (II) und einer auf InP (I) nach dem vorstehend beschriebenen Verfahren hergestellten planaren pin-Photodiode wiedergegeben.

Wie diese Kennlinien zeigen, ist das beschriebene Verfahren dazu geeignet, sowohl bei InGaAs- als auch bei InP-Substraten, Schädigungen der Halbleiteroberfläche bei der Aufbringung von Isolier- oder Passivierschichten zu vermeiden und damit die Herstellung von Bauelementen mit guten und stabilen elektrischen Werten zu ermöglichen.

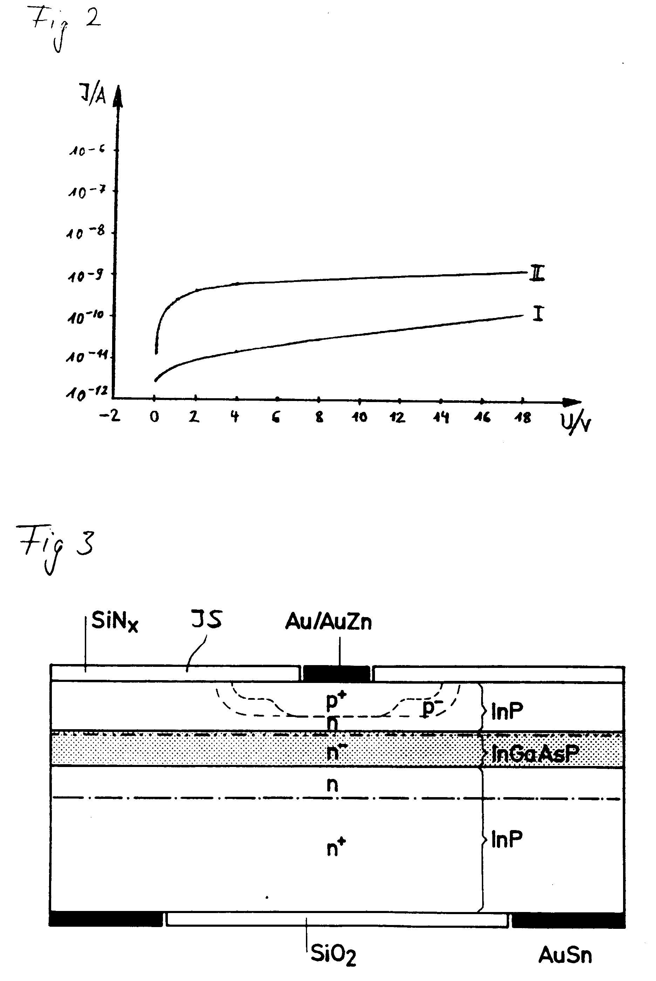

Das beschriebene Verfahren ist nicht auf pin-Photodioden und nicht auf planare Bauelemente beschränkt. Fig. 3 zeigt z.B. schematisch den Aufbau einer planaren Doppel-Hetero-APD, bei der die Passivierschicht IS aus SiNₓ nach Vorbehandlung der Substratoberfläche entsprechend dem beschriebenen Verfahren aufgebracht werden kann. Die Buchstaben n und p geben die Polarität der Dotierungen in den durch die chemische Zusammensetzung ihres Stoffes bezeichneten Halbleiterbereichen an, die zugefügten hochgestellten Vorzeichen + oder - geben ein Maß für den Grad der Dotierung (+ = stark, - = schwach, keine Vorzeichen = normal) an.

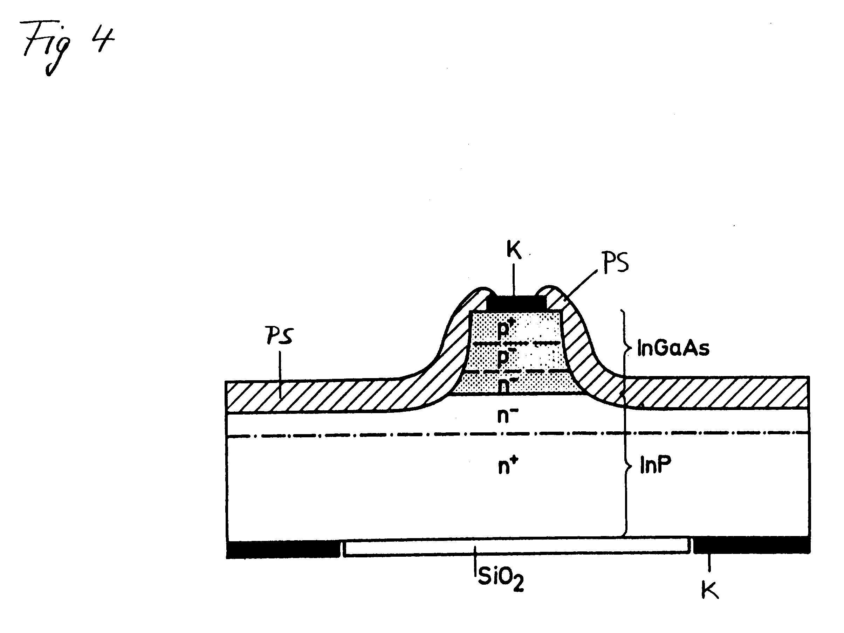

Fig. 4 zeigt eine MESA pin-Diode mit einer nach dem beschriebenen Verfahren aufgebrachten Passivierschicht PS.

## Patentansprüche

1. Verfahren zur Herstellung und Passivierung von Bauelement-Bereichen auf einem III-V-Verbindungshalbleiter-Substrat (S), in welches nach Aufbringen und photolithographischer Strukturierung einer Diffusionsmaskierschicht (IS) Fremdatome eindiffundiert und dadurch dotierte Bereiche (P) geschaffen werden, deren Grenzflächen zum Substrat hin p-n-Übergänge bilden und bei dem vor Aufbringen der Diffusionsmaskierschicht (IS) oder einer Passivierungsschicht (PS) auf das Substrat eine Vorbehandlung der Substratoberfläche durch Einwirkung eines Plasmas in Zuge eines PECVD-Verfahrens erfolgt, wobei das Plasma in einer Atmosphäre angeregt wird, welche mindestens eine Halogen-Kohlenstoff-Verbindung enthält.

2. Verfahren nach Anspruch 1, dadurch gekennzeichnet, daß als Halogen-Kohlenstoff-Verbindung Tetrafluorkohlenstoff (CF₄) verwendet wird.

3. Verfahren nach Anspruch 1 oder 2, dadurch gekennzeichnet, daß die Vorbehandlung der Substratoberfläche und die Aufbringung der Diffusionsmaskierschicht (IS) oder Passivierungsschicht (PS) unmittelbar aufeinanderfolgend in einem PECVD-Parallelplattenreaktor erfolgen.

4. Verfahren nach einem der vorstehenden Ansprüche, dadurch gekennzeichnet, daß als III-V-Verbindungshalbleiter Indiumphosphid InP, Indium-Galliumarsenid InGaAs Indium-Galliumarsenidphosphid InGaAsP, Indium-Aluminiumarsenid InAlAs oder Indium-Gallium-Aluminiumarsenid InGaAlAs und als Diffusionsmaskierschicht (IS) oder Passivierungsschicht (PS) Siliziumdioxid SiO₂, Siliziumnitrid SiₓN_{y} oder Siliziumoxynitrid SiOₓN_{y} verwendet werden.

## Claims

1. A method of forming and passivating device regions on a III-V compound-semiconductor substrate (S) into which, after deposition and photolithographic patterning of a diffusion-masking layer (IS), impurity atoms are diffused to form doped regions (P) whose interfaces to the substrate form pn junctions, and wherein prior to the deposition of the diffusion-masking layer (IS) or a passivating layer (PS), the substrate surface is pretreated by exposing it to a plasma in the course of a PECVD process, the plasma being excited in an atmosphere containing at least one halogen-carbon compound.

2. A method as claimed in claim 1, characterized in that the halogen-carbon compound is tetrafluorocarbon (CF₄).

3. A method as claimed in claim 1 or 2, characterized in that the pretreatment of the substrate surface and the deposition of the diffusion-masking layer (IS) or passivating layer (PS) take place successively in a PECVD parallel-plate reactor.

4. A method as claimed in any one of the preceding claims, characterized in that the III-V compound semiconductor is indium phosphide (InP), indium gallium arsenide (InGaAs), indium gallium arsenide phosphide (InGaAsP), indium aluminum arsenide (InAlAs), or indium gallium aluminum arsenide (InGaAlAs), and that the diffusion-masking layer (IS) or passivating layer (PS) is made of silicon dioxide (SiO₂), silicon nitride (SiₓN_{y}), or silicon oxynitride (SiOₓN_{y}).

## Revendications

1. Procédé pour fabriquer et passiver des zones de composants sur un substrat (S) à semi-conducteurs à liaison III-V dans lequel après application et structuration photolitographique d'une couche masquante de diffusion (IS) des atomes étrangers sont diffusés, formant ainsi des régions (P) dopées dont les interfaces par rapport au substrat forment des jonctions p-n et dans lequel avant application de la couche masquante de diffusion (IS) ou d'une couche de passivation (PS) sur le substrat, un traitement préalable de la surface du substrat par action d'un plasma dans le cadre d'un procédé PECVD est effectué, le plasma étant agité dans une atmosphère contenant au moins une liaison de carbone halogénée.

2. Procédé selon la revendication 1, caractérisé en ce que du tétrafluor de carbone (CF₄) est utilisé comme liaison de carbone halogénée.

3. Procédé selon la revendication 1 ou 2, caractérisé en ce que le traitement préalable de la surface du substrat et l'application de la couche masquante de diffusion (IS) ou de la couche de passivation (PS) s'effectuent immédiatement l'un après l'autre dans un réacteur à plaques parallèles PECVD.

4. Procédé selon l'une des revendications précédentes, caractérisé en ce que le phosphure d'indium (InP), l'arséniure de gallium et d'indium InGaAs, le phosphure d'arséniure de gallium et d'indium InGaAsP, l'arséniure d'aluminium et d'indium InAlAs ou l'arseniure, d'aluminium, de gallium et d'indium InGaAlAs sont utilisés comme semi-conducteurs à liaison III-V et le dioxyde de silicium SiO₂, le nitrure de silicium SiₓN_{y} ou le nitrure d'oxyde de silicium SiOₓN_{y} sont utilisés comme couche masquante de diffusion (IS) ou couche de passivation (PS).
